# EUROPEAN PATENT APPLICATION

(11) **EP 1 915 047 A2**
(43) Date of publication of application: **23.04.2008**
(21) Application number: 07118630.8
(22) Date of filing: 16.10.2007
(51) Int. Cl.: H05K 7/20

(54) **Static inverter with housing for hardened environmental conditions**

(30) Priority: 16.10.2006 US 851981 P
(71) Applicant: Projects Unlimited, Inc., Dayton OH 45414 (US)
(72) Inventor: Spencer, Kelly, Jr., Fairborn, OH Ohio 45324 (US)
(74) Representative: Hagmann-Smith, Martin P.

(57) **Abstract**

A static inverter assembly (10) including a housing (12), a heat sink (26) connected to the housing to define an enclosed three-dimensional volume, the heat sink including at least one channel (28,30,32) extending therethrough, the channel including a plurality of cooling fins (62), a cooling fan (47) positioned relative to the channel to encourage a fluid flow through the channel, and static inverter electronics positioned in the enclosed three-dimensional volume, wherein heat generated by the static inverter electronics is dissipated by the fluid flow through the heat sink.

## Description

The present patent application claims priority from U.S. Ser. No. 60/851,981 filed on October 16, 2006, the entire contents of which are incorporated herein by reference.

### BACKGROUND

The present disclosure relates to inverters and, more particularly, to static inverters for aircraft, marine and vehicle applications.

Static inverters are used on board aircraft, marine vessels and motorized vehicles to convert direct current voltage, typically 12 or 28 volts DC, generated by the associated aircraft, vessel or vehicle, to alternating current suitable for operating accessories and peripheral equipment that may be on board. With some applications, typically military applications, a static inverter must be environmentally hardened; that is, the inverter must be enclosed within a case that is resistant to dust, electromagnetic frequencies (EMF), salt spray, oils and lubricants, and cleaning fluids and solutions. However, such an environmentally hardened enclosure must also be configured to dissipate the heat that is generated during operation of the inverter. It is also desirable to maximize the power generation by the inverter within a minimal space.

### SUMMARY

In one aspect, the disclosed static inverter with hardened environmental housing may include a housing, a heat sink connected to the housing to define an enclosed three-dimensional volume, the heat sink including at least one channel extending therethrough, the channel including a plurality of cooling fins, a cooling fan positioned relative to the channel to encourage a fluid flow through the channel, and static inverter electronics positioned in the enclosed three-dimensional volume, wherein heat generated by the static inverter electronics is dissipated by the fluid flow through the heat sink.

In another aspect, In one aspect, the disclosed static inverter with hardened environmental housing may include a housing, a heat sink connected to the housing to define an enclosed three-dimensional volume, the heat sink including a plurality of generally elongated channels extending therethrough, each channel of the plurality of channels including a plurality of cooling fins, an inlet and an outlet, the inlet and the outlet being exposed to ambient atmosphere, at least one cooling fan positioned generally adjacent to at least one of the inlet and the outlet to encourage a fluid flow through the plurality of channels, static inverter electronics positioned in the enclosed three-dimensional volume, wherein heat generated by the static inverter electronics is dissipated to the ambient atmosphere by the fluid flow through the heat sink, and a connector disposed on the housing and in communication with the static inverter electronics.

Other aspects of the disclosed static inverter with hardened environmental housing will become apparent from the following description, the accompanying drawings and the appended claims.

### BRIEF DESCRIPTION OF THE DRAWINGS

Fig. 1 is a front perspective view of the disclosed static inverter with hardened environmental housing;

Fig. 2 is a rear elevation of the static inverter of Fig. 1;

Fig. 3 is a side elevation of the static inverted of Fig. 1;

Fig. 4 is a front perspective view of the heat sink of the static inverter of Fig. 1; and

Fig. 5 is a rear perspective view of the heat sink of Fig. 4.

### DETAILED DESCRIPTION

The present disclosure is directed to a lightweight, environmentally hardened static inverter that provides relatively high power density in a relatively small volume. These benefits are achieved through the use of an environmentally hardened enclosure that includes an efficient heat sink.

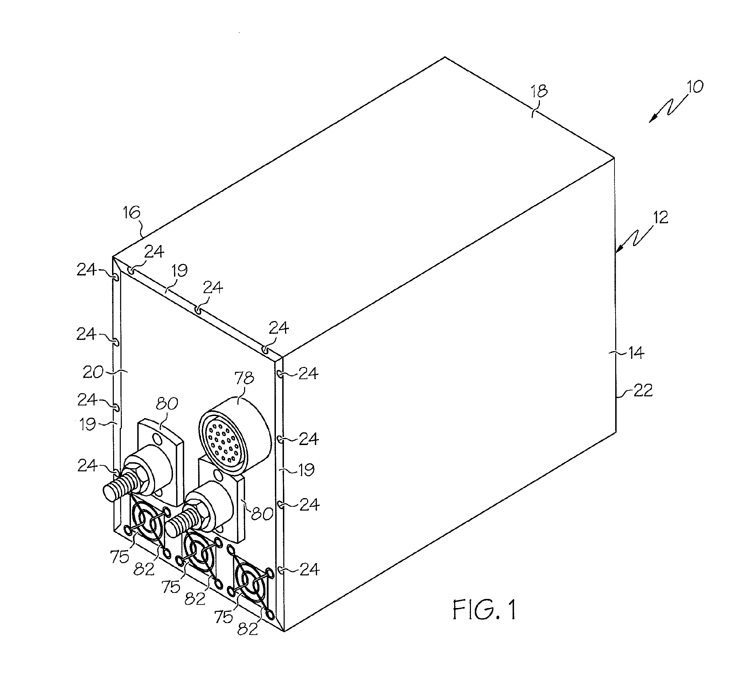

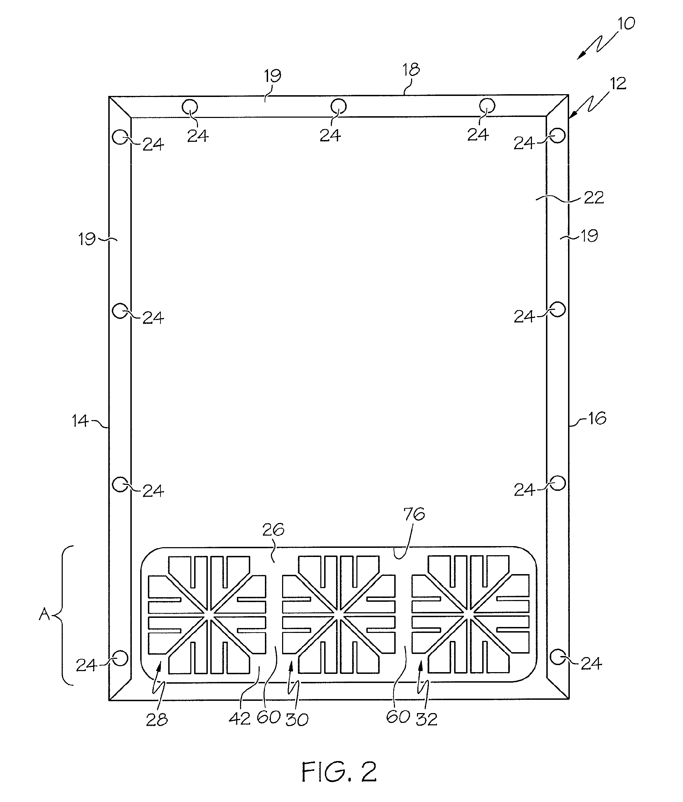

Referring to Fig. 1, one aspect of the disclosed static inverter with hardened environmental housing, generally designated 10, may include a housing 12 having longitudinal side walls 14, 16 and a top wall 18. The housing 12 may also include front and rear end walls 20, 22, respectively. The side walls 14, 16 and the top wall 18 may be unitary in construction and may include flanges 19 (see also Fig. 2) that provide mounting surfaces for the end walls 20, 22. The end walls 20, 22 may be attached to the side walls 14, 16 and top wall 18 by engaging the flanges 19 with a plurality of fasteners 24, such as screws or the like. Optionally, O-rings, gaskets and the like may be positioned between the side and top walls 14, 16, 18 and the end walls 20, 22 to provide a seal from the environment and reduce or eliminate the passage of contaminants, such as dust and rain, across the housing 12.

The housing 12 may be formed from a durable and generally rigid materials, such as metal or hard plastic. Those skilled in the art will appreciate that the selection of material for the housing 12 may be dictated by the intended use of the static inverter assembly 10. For example, naval applications may require a housing 12 capable of withstanding salt water exposure and large temperature fluctuations and, therefore, may be formed from an appropriate composite polymeric material.

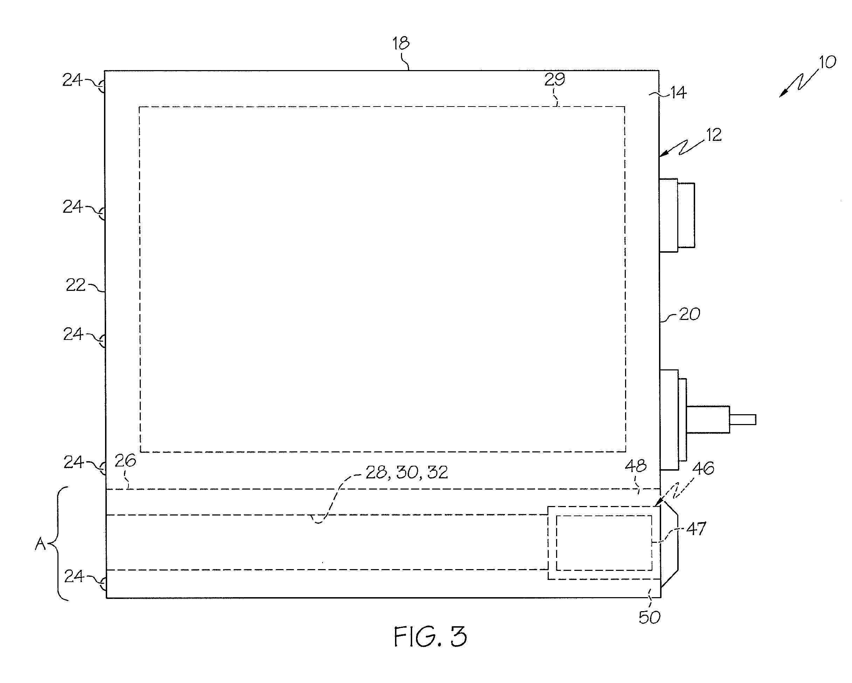

Referring to Figs. 2 and 3, the bottom portion A of the static inverter assembly 10 may include a heat sink 26 that covers and encloses the underside of the housing 12. The heat sink 26 may be made from a cast or extruded metal, such as aluminum alloy. For example, the heat sink 26 may be made by casting aluminum 356/T6 alloy or extruding 6063 aluminum alloy.

While the side walls 14, 16 are shown as extending to cover the heat sink 26 (see Figs. 1-3), those skilled in the art will appreciate that the side walls, 14, 16 could be shorter and could be attached to a corresponding flange (not shown) extending upwardly from the top surface 34 of the heat sink 26.

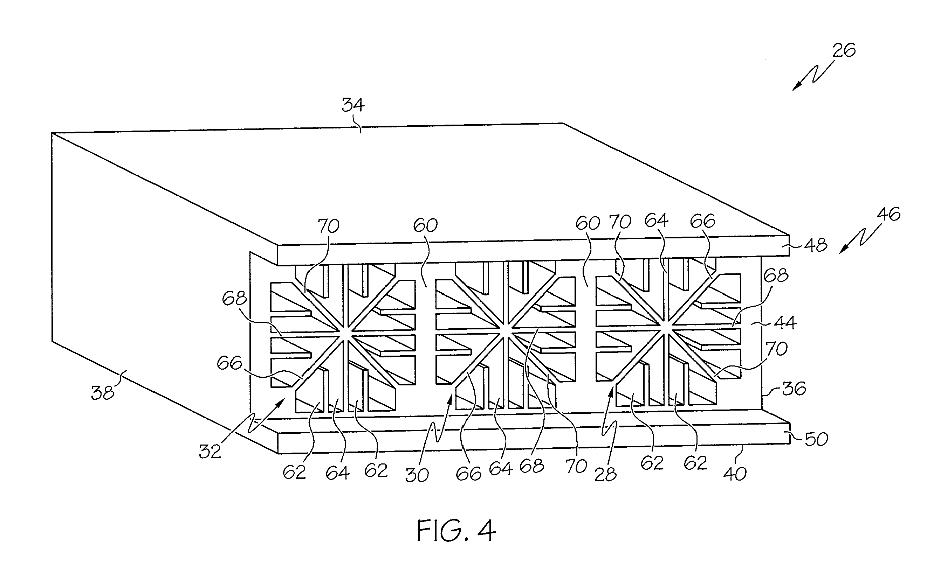

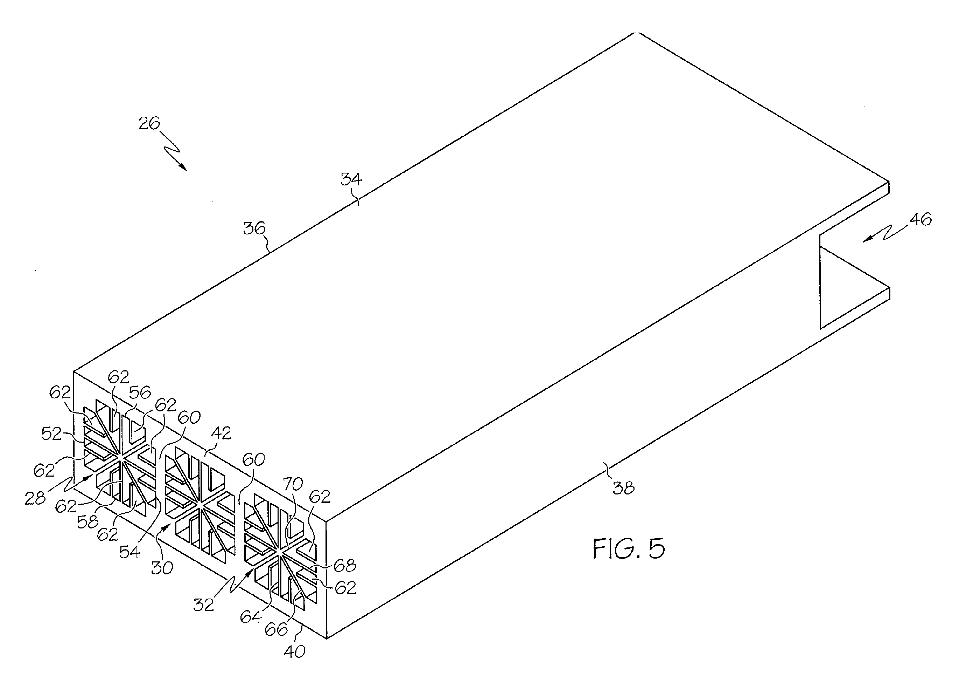

Referring to Figs. 4 and 5, the heat sink 26 may include three interior channels 28, 30, 32 extending therethrough and having an inlet (Fig. 4) and an outlet (Fig. 5). As shown in Fig. 1, the front end wall 20 of the housing 12 may include a cutout or cutouts 75 sized and shaped to align with the channels 28, 30, 32 of the heat sink 26 and expose the channels to the environment. The cutouts 75 may be protected by grates 82 connected to the housing 12 and positioned over the cutouts. Furthermore, as shown in Fig. 2, the rear end wall 22 of the housing 12 may include a cutout portion 76 sized and shaped to align with the channels 28, 30, 32 of the heat sink 26 and expose the channels to the environment. The cutout portion 76 may be protected by a grate (not shown) similar to grates 82.

While reference is made to three channels in the present description and only three channels are illustrated in the drawings, those skilled in the art will appreciate that the heat sink 26 may be provided with a greater or fewer number of channels.

The heat sink 26 may include a top wall 34, two side walls 36, 38, a bottom wall 40 and two end walls 42, 44. The rear end wall 42 of the heat sink 26 may be sized and shaped to engage the end wall 22 of the housing 12 (see Fig. 1). The front end wall 44 of the heat sink 26 may include a notch 46 sized and shaped to receive one or more cooling fans 47 (Fig. 3) therein. An example of an appropriate cooling fan 47 includes a Model MD4028 series high performance DC fan manufactured by Mechatronics Corp. of Preston, Washington. The notch 46 may extend the width of the heat sink 26. The outermost edges 48, 50 of the end 44 may be shaped to engage the end wall 20 of the housing 12 (see Fig. 3).

The channels 28, 30, 32 may be substantially the same in construction or, alternatively, one or more of the channels 28, 30, 32 may have a different geometry than the other channels. In one aspect, each channel 28, 30, 32 may include side walls 52, 54, a top wall 56 and a bottom wall 58. The walls 52, 54, 56, 58 may be offset in a cruciform pattern such that a generally "I-beam" structure 60 is formed between adjacent channels. The walls 52, 54, 56, 58 may include inwardly extending cooling fins 62 that may extend the entire length of the channel 28. Connective cooling fins 64, 66, 68, 70 may be provided that extend across the entire width of the channel 28 to provide structural support. However, those skilled in the art will appreciate that various numbers, arrangements and geometries of cooling fins may be used without departing from the scope of the present disclosure.

Thus, the housing 12 and the heat sink 26 connected thereto may define a three-dimensional volume in which static inverter electronics 29 (Fig. 3) may be contained.

As shown in Fig. 1, the end panel 20 may include a plug connector 78 and other connectors 80 that allow a user to interface with the static inverter electronics 29 (Fig. 3). An example of an appropriate connector 80 is a Model 2201 terminal feed-through connector manufactured by Blue Sea Systems, Inc. of Bellingham, Washington.

Without being limited to any particular theory, it is believed that the I-beam structures 60 (Figs. 2, 4 and 5) conduct heat from the top surface 34 of the heat sink 26, which receives heat from the static inverter electronics 29 within the housing 12 (see Fig. 3), such that the heat is radiated from the cooling ribs 62, 64, 66, 68, 70 and transferred to the fluid (e.g., air) passing through the channels 28, 30, 32. The cooling fan 47 (Fig. 2) may increase convective heat transfer in the channels 28, 30, 32. Therefore, the heat sink 26 may convey a maximum amount of heat to the ambient atmosphere from the electronics positioned on or above the upper surface 34 of the heat sink 26.

Although various aspects of the disclosed static inverter with hardened environmental housing have been shown and described, modifications may occur to those skilled in the art upon reading the specification. The present application includes such modifications and is limited only by the scope of the claims.

Although the invention has been described in terms of preferred embodiments as set forth above, it should be understood that these embodiments are illustrative only and that the claims are not limited to those embodiments. Those skilled in the art will be able to make modifications and alternatives in view of the disclosure which are contemplated as falling within the scope of the appended claims. Each feature disclosed or illustrated in the present specification may be incorporated in the invention, whether alone or in any appropriate combination with any other feature disclosed or illustrated herein.

## Claims

1. A static inverter assembly comprising:
a housing;
a heat sink connected to, integral with, or forming part of, said housing to define a substantially enclosed three-dimensional volume, said heat sink including at least one channel extending therethrough, said channel including a plurality of cooling fins;
a cooling fan positioned relative to said channel to encourage a fluid flow through said channel; and
static inverter electronics positioned in said substantially enclosed three-dimensional volume, wherein heat generated by said static inverter electronics is dissipated by said fluid flow through said heat sink.

2. The assembly of claim 1 wherein said channel includes an inlet and an outlet, said inlet and said outlet being exposed to ambient atmosphere.

3. The assembly of claim 2 further comprising a grate positioned over said inlet.

4. The assembly of claim 1 wherein said substantially enclosed three-dimensional volume is shaped as a generally rectilinear three-dimensional body.

5. The assembly of claim 1 wherein said channel is generally elongated.

6. The assembly of claim 1 wherein said channel has a generally cruciform-shaped cross-section.

7. The assembly of claim 1 wherein at least one of said plurality of cooling fins extends generally inwardly from a wall of said channel.

8. The assembly of claim 1 wherein at least one of said plurality of cooling fins extends across a width of said channel.

9. The assembly of claim 1 further comprising a connector disposed on said housing and in communication with said static inverter electronics.

10. A static inverter assembly comprising:
a housing;
a heat sink connected to, integral with, or forming part of, said housing to define a substantially enclosed three-dimensional volume, said heat sink including a plurality of generally elongated channels extending therethrough, each channel of said plurality of channels including a plurality of cooling fins, an inlet and an outlet, said inlet and said outlet being exposed to ambient atmosphere;
at least one cooling fan positioned generally adjacent to at least one of said inlet and said outlet to encourage a fluid flow through said plurality of channels;
static inverter electronics positioned in said substantially enclosed three-dimensional volume, wherein heat generated by said static inverter electronics is dissipated to said ambient atmosphere by said fluid flow through said heat sink; and
a connector disposed on said housing and in communication with said static inverter electronics.

11. The assembly of claim 10 wherein at least one of said plurality of cooling fins extends generally inwardly from a wall of an associated one of said plurality of channels.

12. The assembly of claim 10 wherein at least one of said plurality of cooling fins extends across a width of an associated one of said plurality of channels.

13. The assembly of any preceding claim wherein said housing includes at least two side walls, at least two end walls and at least one top wall, wherein said side walls and said end walls are connected to said heat sink.

14. The assembly of any preceding claim wherein said housing is formed as a unitary structure.

15. The assembly of any preceding claim wherein said heat sink is formed from an aluminum alloy.

16. The assembly of any preceding claim wherein said heat sink includes a front end wall having a notch formed therein, said cooling fan being positioned in said notch.
